(19) Europäisches Patentamt / European Patent Office / Office européen des brevets

(11) **EP 4 523 902 A1**

(12) **EUROPEAN PATENT APPLICATION**
published in accordance with Art. 153(4) EPC

(43) Date of publication:
**19.03.2025 Bulletin 2025/12**

(21) Application number: 23823936.2

(22) Date of filing: **13.06.2023**

(51) International Patent Classification (IPC):
**B32B 15/02** (2006.01) **B32B 9/00** (2006.01)
**B05D 5/12** (2006.01)

(52) Cooperative Patent Classification (CPC):
**B05D 5/12; B32B 9/00; B32B 15/02**

(86) International application number:
**PCT/JP2023/021985**

(87) International publication number:
**WO 2023/243646 (21.12.2023 Gazette 2023/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.06.2022 PCT/JP2022/023687**

(71) Applicant: Resonac Corporation
Tokyo 105-7325 (JP)

(72) Inventors:
• MORIHARA, Masumi
Tagawa-shi, Fukuoka 825-0005 (JP)
• FUJINO, Hiroaki
Tagawa-shi, Fukuoka 825-0005 (JP)
• YAMAMOTO, Kazuki
Tokyo 105-8518 (JP)
• HIRANO, Hiroki
Tokyo 105-8518 (JP)

(74) Representative: Hoffmann Eitle
Patent- und Rechtsanwälte PartmbB
Arabellastraße 30
81925 München (DE)

(54) **SENSOR COVER**

(57) A sensor cover includes a substrate, and a silver particle layer provided on the substrate, the silver particle layer including a silver particle, in which the silver particle has an electromagnetic wave transmission layer on a surface thereof.

**FIG. 1**

EP 4 523 902 A1

**Description**

Technical field

The present disclosure relates to a sensor cover.

Background Art

In recent years, interest in millimeter wave sensors has been growing.

For example, in recent years, automobile safety devices have made remarkable advances, and for example, an automatic collision avoidance system is becoming commonplace.

The automatic collision avoidance system automatically applies the brakes using image data from an onboard camera and relative distance information to an object obtained from a millimeter-wave radar.

Furthermore, with the growing interest in energy conservation, resource conservation, safety and health, the use of millimeter wave sensors in buildings such as homes has also attracted attention. In addition to the conventional function of automatically switching on or off when the infrared human detecting sensors detects a people, hand or the like, millimeter wave sensors can also detect the movement of objects such as people, making it possible to detect falls and monitor health conditions such as pulse and respiratory rate.

Conventional sensor covers for human detecting sensors have mainly been made of flat or curved plastic plates, which lacked design and aesthetic appeal. However, in a case in which a sensor cover is given a metal plating layer to give it a metallic appearance that creates a clean and luxurious look, the sensor placed behind it will not function because the metal plating layer does not transmit either millimeter waves or infrared rays.

As a material to replace the metal plating layer, which forms a metallic surface and transmits millimeter waves, an indium vapor deposition film, a metal-like film or the like are known (for example, Japanese Patent Application Laid-Open (JP-A) No. JP 2022-082052 A).

SUMMARY OF INVENTION

However, the indium vapor deposition film does not provide an adequate metallic appearance, and metal-like films are difficult to decorate with complex design shapes.

Similarly, for infrared sensors, which are widely used as human detecting sensors, there is also a demand for sensor covers with a metallic appearance that creates a clean and luxurious look.

The present disclosure has been made in consideration of the above circumstances, and aims to provide a sensor cover that has excellent metallic luster and excellent electromagnetic wave transmittance.

Solution to Problem

Means for solving the above problems include the following embodiments.

<1> A sensor cover including a substrate, and a silver particle layer provided on the substrate, the silver particle layer including a silver particle,
in which the silver particle has an electromagnetic wave transmission layer on a surface thereof.
<2> The sensor cover according to <1>, in which the electromagnetic wave transmission layer is an organic layer.
<3> The sensor cover according to <1> or <2>, in which the silver particle includes a secondary particle, and the electromagnetic wave transmission layer is provided on a surface of a primary particle of the silver particle.
<4> The sensor cover according to any one of <1> to <3>, in which the electromagnetic wave transmission layer is a millimeter wave transmission layer.
<5> The sensor cover according to any one of <1> to <4>, in which the electromagnetic wave transmission layer is a layer that transmits at least a part of wavelengths in a range from infrared to visible light.
<6> The sensor cover according to any one of <1> to <5>, the sensor cover being a cover for a millimeter wave sensor or an infrared sensor.

Advantageous Effects of Invention

In the present disclosure, it is possible to provide a sensor cover that has excellent metallic luster and excellent electromagnetic wave transmittance.

BRIEF DESCRIPTION OF DRAWINGS

FIG. 1 is a scanning transmission electron microscope (STEM) photograph of a silver particle layer obtained in the Example.

FIG. 2 is a transmission electron microscope - energy dispersive X-ray spectroscopy (TEM-EDX) image of a silver particle layer obtained in the Example.

FIG. 3 is a spectral transmittance spectra in a range from infrared to ultraviolet for layered body A produced in the Example and polycarbonate substrate B alone.

FIG.4 is a spectral reflectance spectra in a range from infrared to ultraviolet for layered body A produced in the Example and polycarbonate substrate B alone.

DESCRIPTION OF EMBODIMENTS

Hereinafter, embodiments in the present invention will be described in detail. However, the present invention is not limited to the following embodiments. In the following embodiments, the components (including element steps, or the like.) are not essential unless otherwise specified. The same applies to the numerical values and their ranges, and they do not limit the present invention.

In the present specification, in a case in which a numerical range is indicated using "to", the numerical values before and after "to" are included as the minimum and maximum values, respectively.

In the present invention, in the numerical ranges described in stepwise, the upper limit or lower limit value described in a certain numerical range can also be replaced with the upper limit or lower limit value of another numerical range described in stepwise. In the numerical ranges described in the present disclosure, the upper or lower limit value of the numerical range may be replaced by the value shown in each example.

In the present disclosure, each component may contain two or more types of corresponding substances. In a case in which a composition contains two or more substances corresponding to each component, a content or amount of each component means a total content or amount of the two or more substances present in the composition, unless otherwise specified.

In the present disclosure, particles corresponding to each component may include multiple types of particles. In a case in which multiple types of particles corresponding to each component are present in the composition, a particle size of each component means a value for a mixture of the multiple types of particles present in the composition, unless otherwise specified.

In the present disclosure, the terms "layer" and "film" include cases where the layer or film is formed over the entire area when the area is observed, as well as cases where the layer or film is formed only in a part of the area.

<Sensor Cover>

A sensor cover includes a substrate, and a silver particle layer provided on the substrate, the silver particle layer including a silver particle, in which the silver particle has an electromagnetic wave transmission layer on a surface thereof.

The sensor cover in the present disclosure has excellent metallic luster and excellent electromagnetic wave transmittance. The reason for this is not clear, but is presumed to be as follows.

The silver particle in the silver particle layer tend to aggregate, and in this case, electromagnetic waves (e.g., a millimeter wave) either do not pass through or have difficulty passing through a gap between the silver particles. Therefore, in the present disclosure, an electromagnetic wave transmission layer is provided on a surface of the silver particle. It is believed that a presence of the electromagnetic wave transmission layer creates a gap between the silver particles, and electromagnetic waves pass through the gap. In a case in which silver particles that have an electromagnetic wave transmission layer on their surface are used, even if filling rate of the silver particles is increased, electromagnetic waves can still pass through, so the filling rate of the silver particles can be increased and the metallic luster is excellent.

Each component used in the present disclosure will be described below.

-Substrate-

A material of a substrate is not particularly limited, and an inorganic material such as a glass, an organic material such as a resin or the like may be used. Examples of the resin include a thermosetting resin and a thermoplastic resin.

Examples of the thermoplastic resin include a polyethylene, a polypropylene, a polycarbonate, a polystyrene, a polyvinyl chloride, a vinyl polymer, a polyester, a polyamide, an ABS resin (acrylonitrile-butadiene-styrene copolymer resin), a polyester, a thermoplastic elastomer, and an acrylic resin. The resin may be used singly or in combination of two or more types. An example of a combination of two or more types includes a polycarbonate/an ABS resin.

Examples of the thermosetting resin include a silicone resin, a polyurethane resin, a polyester resin, a melamine resin, an epoxy resin, a phenolic resin, and a urea resin. These resin may be used singly or in combination of two or more types.

In a case in which the sensor cover is used, for example, it is preferable to use a polypropylene, a polycarbonate, an ABS resin, a polycarbonate/an ABS, an acrylic resin or the like as the material of the substrate. Polypropylene has a low specific gravity among resins, is easy to process, has high tensile strength, impact strength and compressive strength, and is also excellent in weather resistance and heat resistance. ABS resin is relatively easy to apply surface treatment to among plastic materials, and is therefore easy to apply paint after molding of the substrate, and is excellent in chemical resistance and rigidity, as well as impact resistance, heat resistance, and cold resistance. Polycarbonate has high impact resistance among plastic materials, is excellent in weather resistance and heat resistance, and is also excellent in transparency. Polycarbonate is also easy to process, and is a relatively light and strong material among plastic materials.

The substrate may be provided with an undercoat layer to improve adhesion between the substrate and the silver particle layer, smooth the substrate surface or the like. A material for the undercoat layer is not particularly limited and may be selected according to a purpose of the undercoat layer. For example, a fluororesin, a polyester resin, an epoxy resin, a melamine resin, a silicone resin, an acrylic silicone resin, an acrylic urethane resin or the like may be used. The resin may be in the form of paint to which a solvent or the like has been added.

A thickness of the undercoat layer is not particularly limited, and from the viewpoint of ensuring a smooth surface, it is preferably about from 5 $\mu$m to 25 $\mu$m.

In order to increase the adhesion between the undercoat layer and the substrate, a primer layer may be provided between the undercoat layer and the substrate.

A thickness of the substrate can be appropriately designed depending on an uses of the sensor cover. A shape of the substrate is not particularly limited.

-Silver particle layer-

A silver particle layer includes a silver particle having an electromagnetic wave transmission layer on a surface thereof. The silver particle layer may be formed by silver mirror reaction. The silver particle included in the silver particle layer may include a silver particle deposited by silver mirror reaction (i.e., a deposited silver particle). Furthermore, the silver particle layer may have a sea-island structure in which the silver particles are scattered like islands.

The formation of the silver particle layer by silver mirror reaction may be performed by contacting an ammoniacal silver nitrate aqueous solution with a reducing agent aqueous solution. This causes an oxidation-reduction reaction to generate a silver particle, and the silver particle layer is formed.

In one embodiment in the present disclosure, the ammoniacal silver nitrate aqueous solution is obtained by dissolving silver nitrate, ammonia, and at least one amine compound selected from the group consisting of an amino alcohol compound, an amino acid and an amino acid salt, in water.

Specific examples of the amine compound include an amino alcohol compound such as monoethanolamine, diethanolamine, diisopropanolamine, triethanolamine and triisopropanolamine, an amino acid such as glycine, alanine, and sodium glycine, and a salt thereof.

A content of silver nitrate, ammonia and the amine compound contained in the ammoniacal silver nitrate aqueous solution is not particularly limited.

A concentration of silver nitrate contained in the ammoniacal silver nitrate aqueous solution is not particularly limited, and from the viewpoint of controlling a reaction rate, it is preferable to adjust it to a range from 0.1% by mass to 10% by mass.

A pH of the ammoniacal silver nitrate aqueous solution is preferably adjusted to between 10 and 13, and more preferably between 11 and 12.

In one embodiment in the present disclosure, the reducing agent aqueous solution is obtained by dissolving a reducing agent containing a phenolic compound and a strong alkaline component in water.

The phenol compound contained in the reducing agent include a benzenediol compound such as hydroquinone, catechol and resorcinol, and among them, hydroquinone is preferable.

The reducing agent may be the phenolic compound alone, or a combination of the phenolic compound and a compound other than a phenolic compound. Examples of the compound other than a phenolic compound include a hydrazine compound such as hydrazine sulfate, hydrazine carbonate and hydrazine hydrate, a sulfite salt compound such as sodium sulfite, and a thiosulfate salt compound such as sodium thiosulfate.

In a case in which the reducing agent contains the phenolic compound and the compound other than a phenolic compound, a proportion of the phenolic compound in the entire reducing agent is preferably 50% by mass or more, more preferably 70% by mass or more, and even more preferably 90% by mass or more.

Specific examples of the strong alkaline component contained in the reducing agent aqueous solution include sodium hydroxide and potassium hydroxide.

The reducing agent aqueous solution may contain the above-mentioned amine compound if necessary. The reducing agent aqueous solution may contain a compound containing a formyl group if necessary. Specific examples of the compound containing a formyl group include glucose and glyoxal. Contents of the reducing agent, the strong alkaline component, the amine compound contained as necessary, and the compound containing a formyl group contained as necessary in the reducing agent aqueous solution are not particularly limited.

A concentration of the reducing agent contained in the reducing agent aqueous solution is not particularly limited, and from the viewpoint of controlling a reaction rate, it is preferable to adjust it to a range from 0.1% by mass to 10% by mass. A pH of the reducing agent aqueous solution is preferably adjusted to a range from 10 to 13, and more preferably adjusted to a range from 10.5 to 11.5.

An average primary particle size of the silver particles in the silver particle layer is preferably from 1 nm to 30 nm, more preferably from 5 nm to 25 nm, and even more preferably from 10 nm to 20 nm. In a case in which the average primary particle diameter of the silver particles in the silver particle layer is 15 nm or more, a uniformity of the silver particle layer is excellent and an appearance is improved.

The silver particles in the silver particle layer may be aggregated to form secondary particles, and the average secondary particle diameter is preferably 350 nm or less, more preferably 300 nm or less, and even more preferably 250 nm or less.

The average primary particle diameter and average secondary particle diameter of the silver particles are determined by measuring diameters of 50 silver particles using a scanning microscope (SEM) image or a transmission electron microscope (TEM) image, and taking an arithmetic average of the diameters.

The electromagnetic wave transmission layer provided on a surface of the silver particle is not limited as long as it transmits electromagnetic waves. Examples of the electromagnetic wave include a millimeter wave and a microwave, and the electromagnetic wave transmission layer is preferably a millimeter wave transmission layer that transmits a millimeter wave. The electromagnetic wave transmission layer is preferably a layer that transmits at least a part of wavelengths in a range from infrared to visible light.

An example of an electromagnetic wave transmission layer is an organic layer.

The organic layer may be composed of the reducing agent used in the silver mirror reaction, a compound derived from the reducing agent, or a combination of these. For example, in a case in which hydroquinone is used as the reducing agent, the organic layer may be composed of hydroquinone, benzoquinone which is an oxidized form of hydroquinone, or a combination of hydroquinone and benzoquinone.

An average thickness of the electromagnetic wave transmission layer is preferably from 20 nm to 400 nm, more preferably from 50 nm to 400 nm, even more preferably from 70 nm to 350 nm, and particularly preferably from 100 nm to 250 nm. In a case in which the average thickness of the electromagnetic wave transmission layer is 400 nm or less, an electromagnetic wave transmission is excellent, and in a case in which it is 20 nm or more, a uniformity of the silver particle layer is excellent and an appearance is improved.

An average thickness of the electromagnetic wave transmission layer is obtained by measuring a thickness of 50 points of the electromagnetic wave transmission layer using a scanning transmission electron microscope (STEM) image or a transmission electron microscope-energy dispersive X-ray spectroscopy (TEM-EDX) image, and taking an arithmetic average of the measured values.

In a case in which the silver particles are aggregated to form secondary particles, it is preferable that the electromagnetic wave transmission layer is provided on a surface of a primary particle of the silver particle. In a case in which an electromagnetic wave transmission layer is provided on the surface of the primary particle of the silver particle, even if the silver particles form secondary particles, gaps are provided between the primary particles due to a presence of the electromagnetic wave transmission layer, and electromagnetic waves can pass through these gaps, resulting in excellent electromagnetic wave transmission.

The electromagnetic wave transmission layer may be provided on an entire surface of the silver particle or may be provided partially. The electromagnetic wave transmission layer may also be an aggregate of granular matter.

A thickness of the silver particle layer formed on the substrate is not particularly limited. From the viewpoint of obtaining a sufficient metallic luster, the thickness of the silver particle layer is preferably 50 nm or more, and from the viewpoint of obtaining sufficient millimeter wave transmission, the thickness of the silver particle layer is preferably 300 nm or less.

When observing a cross section of the silver particle layer in a thickness direction, a proportion of the silver particle in the silver particle layer is preferably 95% or less. In a case in which the proportion of the silver particle in the silver particle layer is 95% or less, the millimeter wave transmission tends to be further improved. From the viewpoint of obtaining a sufficient metallic luster, the proportion of the silver particle in the silver particle layer is preferably 80% or more.

The proportion of the silver particle in the silver particle layer refers to a value measured as follows.

A cross section of the silver particle layer in the sensor cover in the thickness direction was photographed using a transmission electron microscope at a magnification of 300,000 times. On the obtained electron microscope photograph, a center line passing through a center of the silver particle layer in the thickness direction is determined. Next, a length of a part where the center line overlaps with the silver particles is determined. A percentage of the length of the part where the center line overlaps with the silver particles divided by a total length of the center line is defined as the proportion of silver particles in the silver particle layer.

A surface resistivity of the silver particle layer is preferably $10^5$ Ω/sq. or more, and more preferably $10^6$ Ω/sq. or more. In a case in which the surface resistivity of the silver particle layer is within the above range, it can be determined that sufficient millimeter wave transmittance has been achieved. An upper limit of the surface resistivity of the silver particle layer is not particularly limited.

The surface resistivity of the silver particle layer refers to a value measured in accordance with JIS K6911:2006.

-Topcoat layer-

The sensor cover may have layers other than the substrate and the silver particle layer as necessary. For example, a topcoat layer may be provided on or above the silver particle layer for the purpose of protecting the silver particle layer.

The topcoat layer is preferably transparent to such an extent that it does not hide the metallic luster of the silver particle layer, and is also transmissive to such an extent that it does not block millimeter waves, and may be colorless clear (colorless and transparent) or colored clear (colored and transparent).

A material of the topcoat layer is not particularly limited, and may be selected from the resins mentioned above as the material of the undercoat layer of the substrate.

A thickness of the topcoat layer is not particularly limited, and is preferably about from 20 μm to 40 μm. In a case in which the thickness of the topcoat layer is 20 μm or more, the silver particle layer tends to be sufficiently protected, and in a case in which it is 40 μm or less, cracks, peeling, poor adhesion or the like due to deterioration over time tend to be less likely to occur.

<Physical properties of sensor cover>

The sensor cover preferably has a transmission attenuation of 3.0 dB or less at 77.0 GHz, which is the millimeter wave range, more preferably 2.0 dB or less, and even more preferably 1.0 dB or less.

The transmission attenuation of the sensor cover is measured in accordance with JIS R1679:2007 (Measurement methods for reflectivity of electromagnetic wave absorber in millimetre wave frequency). It is calculated from the transmitted wave (transmission coefficient) obtained by a free space method in which a sample is placed between a transmitting antenna and a receiving antenna and electromagnetic waves are irradiated perpendicularly to the sample. The transmission attenuation can be calculated from the following formula using the transmission coefficient (absolute value).

$$\text{Transmission attenuation} = 20 \log_{10} | (\text{transmission coefficient}) |$$

A spectral transmittance at a wavelength of 800 nm in the infrared region is preferably 5% or more, and a spectral transmittance at wavelengths from 900 nm to 1600 nm is preferably 10% or more.

A spectral transmittance at a wavelength of 400 nm in the visible light region is preferably 1% or more, and a spectral transmittance at wavelengths from 500 nm to 600 nm is preferably 0.05% or more, and a spectral transmittance at a wavelength of 700 nm is preferably 1% or more.

It has been confirmed that even if the spectral transmittance at a wavelength of 580 nm in the measurement method described below is about 0.1%, the color can be sufficiently distinguished by visual inspection.

A spectral reflectance at a wavelength of 400 nm in the visible light region is preferably 40% or more, a spectral reflectance at a wavelength of 500 nm is preferably 60% or more, a spectral reflectance at a wavelength of 600 nm is preferably 50% or more, and a spectral reflectance at a wavelength from 700 nm to 800 nm is preferably 35% or more. The spectral transmittance and spectral reflectance of the sensor cover in the infrared to visible wavelength range are measured at 25°C in air using an ultraviolet-visible-near infrared (UV-VIS-NIR) spectrophotometer.

<Method of producing sensor cover>

A method of producing of the sensor cover is not particularly limited. A method of forming the silver particle layer by silver mirror reaction is described below.

In forming a silver particle layer by silver mirror reaction, a method of contacting the ammoniacal silver nitrate aqueous solution with the reducing agent aqueous solution is not particularly limited, and examples thereof include a method of applying these aqueous solutions to a surface of a substrate in a mixed or unmixed state.

The method of applying an ammoniacal silver nitrate aqueous solution and a reducing agent aqueous solution to a surface to be treated by silver mirror reaction is not particularly limited. Among these, spray application is preferable because it may form a uniform silver particle layer regardless of a shape of the substrate. Spray application may be performed using a known mean such as an airbrush or a spray gun.

In a case in which the electromagnetic wave transmission layer is composed of a reducing agent, a compound derived from a reducing agent or a combination of these, it is preferable to perform the above spray application in the following manner from the viewpoint of more reliably forming the electromagnetic wave transmission layer on the surface of the silver particles.

Separate airbrushes are used for the ammoniacal silver nitrate aqueous solution and the reducing agent aqueous solution. Then, a position and discharge direction of the airbrush are fixed, while the substrate is moved, and the solutions are sprayed onto an entire surface of the substrate. It is preferable to adjust the spray application positions of the ammoniacal silver nitrate aqueous solution discharged and the spray application position of the reducing agent aqueous solution, which are discharged from separate airbrushes, so as to overlap each other.

By fixing the position and discharge direction of the airbrush, discharge conditions of each liquid are made constant, making it possible to uniformly and reliably form the electromagnetic wave transmission layer on the surface of the silver particle. There is no particular restriction on the manner in which the substrate is moved, and the substrate may be rotated or slid. Furthermore, in the method, the spray application from the airbrush and the movement of the substrate may be automated.

An amount of each liquid discharged from the airbrush may be, for example, from 1g/10 seconds to 10g/10 seconds, and is preferably from 4g/10 seconds to 8g/10 seconds.

If necessary, a surface activation treatment may be performed on the surface of the substrate before the silver particle layer is formed.

In one embodiment in the present disclosure, a surface activation treatment liquid containing an inorganic tin compound is applied to the surface of the substrate as the surface activation treatment. This causes tin to be present on the surface of the substrate. The presence of tin between the silver particle layer and the substrate tends to improve an adhesion between the substrate and the silver particles.

Examples of the inorganic tin compound contained in the surface activation treatment liquid include inorganic tin compounds such as tin(II) chloride, tin(II) oxide, and tin(II) sulfate.

In addition to the inorganic tin compound, the surface activation treatment liquid may contain hydrogen chloride, hydrogen peroxide, polyhydric alcohol or the like, as necessary.

A content of these components contained in the surface activation treatment liquid is not particularly limited.

A pH of the surface activation treatment liquid is preferably adjusted to between 0.5 and 3.0, and more preferably between 0.5 and 1.5.

Examples of a method of applying the surface activation treatment liquid to the surface of the substrate include a method of immersing the substrate in the surface activation treatment liquid, and a method of applying the surface activation treatment liquid to the surface of the substrate. Among these, spray application is preferable because it may be applied uniformly regardless of a shape of the substrate.

After the surface activation treatment, it is preferable to remove excess surface activation treatment liquid adhering to the surface of the substrate. For example, it is preferable to wash the surface of the substrate with deionized water or purified distilled water.

If necessary, a pretreatment may be performed on the surface of the substrate before the silver particle layer is formed. In one embodiment in the present disclosure, as the pretreatment, a pretreatment liquid such as the silver nitrate aqueous solution is applied to the surface of the substrate after the above-mentioned surface activation treatment. This allows silver to be present on the surface of the substrate. The presence of silver between the silver particle layer and the substrate tends to make it easier for silver particles of uniform size to deposit.

A pH of the pretreatment liquid is preferably adjusted to between 4.0 and 8.0, and more preferably between 6.0 and 7.0.

Examples of a Method of applying the pretreatment liquid to the surface of the substrate include a method of immersing the substrate in the pretreatment liquid and a method of applying the pretreatment liquid to the surface of the substrate. Among these, spray application is preferred because it may be applied uniformly regardless of a shape of the substrate.

If necessary, a deactivation treatment may be performed after forming a silver particle layer on the surface of the substrate.

In one embodiment in the present disclosure, the deactivation treatment is performed by contacting the silver particle layer with a deactivation treatment liquid, which is an aqueous solution containing a strong alkaline component such as potassium hydroxide and a sulfite salt such as sodium sulfite. This may reduce the reaction activity between the silver in the silver particle layer and residual ions such as a chloride ion and a sulfide ion.

A content of the components contained in the deactivation treatment liquid is not particularly limited.

A pH of the deactivation treatment liquid is preferably adjusted to between 4.0 and 8.0, and more preferably between 7.0 and 8.0.

Examples of a method of contacting the silver particle layer with the deactivation treatment liquid include a method of immersing the substrate on which the silver particle layer is formed in the deactivation treatment liquid, and a method of applying the deactivation treatment liquid to the silver particle layer. Among these, spray application is preferred because it may be applied uniformly regardless of a shape of the substrate.

Before and after the deactivation treatment, it is preferred to wash the silver particle layer with deionized water or purified distilled water.

<Uses of Sensor Cover>

The sensor cover in the present disclosure has excellent metallic luster and excellent electromagnetic wave transmittance. For this reason, it can be particularly suitably used as a cover with excellent design for various sensors.

Examples of the sensor include a millimeter wave sensor and an infrared sensor, which may be used as a sensor for detecting human movement, monitoring health conditions, and the like. The sensor cover in the present disclosure may be used as a cover for an indoor or outdoor sensor such as a vital signs sensor, a security motion sensor, an automatic faucet sensor, a toilet seating and leaving sensor, an automatic toilet seat opening and closing sensor, an automatic flushing sensor, an automatic lighting sensor, an elderly monitoring sensor, an automatic door sensor, a detection type escalator sensor, a remote controller sensor, a noncontact body temperature sensors, a s detection type traffic light sensor, and a traffic volume measurement sensor.

The detection targets may be things other than people, and examples thereof may include a bicycle, an automobile, an airplane, other transport vehicles, an animal, a plant, and goods (precious metals, etc.).

Since the exterior is mirror like, it may be placed in place of an existing mirror, or it may be placed as interior or exterior equipment.

Examples

The present disclosure will be described below based on examples, but the present disclosure is not limited to the following examples.

<Examples>

(1) Preparation of substrate

A surface of a 2 mm thick polycarbonate substrate was wiped with a cloth soaked in isopropyl alcohol to remove oil layer, dirt and dust, and then the substrate was dried.

(2) Surface activation process

The substrate on which an undercoat layer was formed was spray-washed with pure water, and then a surface activation treatment liquid (MSPS-Sa1A, manufactured by Mitsubishi Paper Mills Ltd.) was spray-applied. It was then spray-washed with pure water. The surface activation treatment liquid used was an aqueous solution of pH 1.0 containing tin(II) chloride, hydrogen chloride, hydrogen peroxide, and a polyhydric alcohol.

(3) Pretreatment process

A pretreatment liquid (MSPS-Sa2A, manufactured by Mitsubishi Paper Mills Ltd.) was spray-coated on a surface of the substrate after the surface activation treatment. It was then spray-washed with pure water. The pretreatment liquid used was a silver nitrate aqueous solution with a pH of 6.8.

(4) Silver particle layer formation process

An ammoniacal silver nitrate aqueous solution and a reducing agent aqueous solution were prepared. The ammoniacal silver nitrate aqueous solution was an aqueous solution with a pH of 11.5 (silver nitrate concentration: 0.5% by mass) containing silver nitrate, ammonia, and triethanolamine. The reducing agent aqueous solution was an aqueous solution with a pH of 10.8 (hydroquinone concentration: 4.5% by mass) containing hydroquinone, triethanolamine, sodium hydroxide, and amino alcohol.

The ammoniacal silver nitrate aqueous solution and the reducing agent aqueous solution were simultaneously sprayed from separate airbrushes. The position and discharge direction of each airbrush were fixed. The pretreated substrate was attached to a rotating support member, and while rotating the substrate horizontally, each liquid was sprayed from the airbrush toward the substrate. The substrate rotation speed was 120 rpm. The discharge rate from each airbrush was 1.0g/10 sec to 1.5g/10 sec. Silver particles were precipitated on the substrate surface by the silver mirror reaction, and a silver particle layer (thickness: 0.2 $\mu$m) with a silver luster was formed. After that, it was spray-washed with pure water.

(5) Inactivation treatment process

The substrate surface after the silver particle layer formation process was sprayapplied with an inactivation treatment liquid (MSPS-R1A, manufactured by Mitsubishi Paper Mills Co., Ltd.). It was then spray-washed with pure water. The inactivation treatment liquid used was an aqueous solution of pH 7.5 containing potassium hydroxide and sulfite salt.

<Comparative Example>

A silver particle layer (thickness: 0.13 $\mu$m) was formed on a substrate in the same manner, except that an aqueous solution containing hydrazine sulfate (pH 10.1) was used instead of hydroquinone as the reducing agent aqueous solution.

<Evaluation>

(1) Measurement of surface resistivity

A surface resistivity of the silver particle layer of the layered bodies prepared in the example and comparative example was measured by the four-probe method using a low resistivity meter (product name: Loresta EP, manufactured by Dia Instruments Co., Ltd.). The surface resistivity of the silver particle layer in the example was 5.08E05 $\Omega$/sq., and the surface resistivity of the silver particle layer in the comparative example was 4.28E00 $\Omega$/sq.
According to the surface resistivity value of the comparative example, it is presumed that no electromagnetic wave transmission layer is formed on the surface of the silver particle.

(2) Electron Microscope Observation

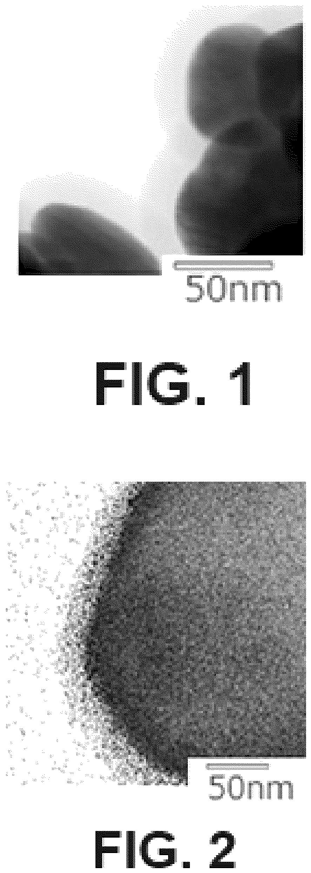

The silver particle layer of the example was observed with an electron microscope. FIG. 1 is a photograph taken with a scanning transmission electron microscope (STEM) (JEM-2100F, manufactured by JEOL Ltd.), and FIG. 2 is an image taken with a transmission electron microscope-energy dispersive X-ray spectroscopy (TEM-EDX).
As shown in FIGs 1 and 2, it was confirmed that an organic layer was present on the surface of the silver particles of the example. An average thickness of the organic layer was 25 nm.

(3) Appearance Observation

The appearance of the samples obtained in the example was observed, and a metallic gloss was evaluated. Both the example and the comparative example had excellent metallic gloss.

(4) Measurement of millimeter wave transmission attenuation

A composition for the topcoat layer was prepared by mixing MSPS Topcoat Clear M, MSPS Topcoat Thinner P-7, and MSPS Topcoat Curing Agent W (manufactured by Ohashi Chemical Industry Co., Ltd.) in a ratio of 20:20:5 (parts by mass).
The composition was sprayed onto the silver particle layer of the samples of the examples and comparative examples to form a topcoat layer with a thickness of 25 $\mu$m.
The attenuation (transmission attenuation) when millimeter waves (77.0125 GHz) were transmitted through the layered body with the topcoat layer formed was measured using the following method.
The transmission attenuation was calculated from the transmitted wave (transmission coefficient) obtained by free space method, in which a sample is placed between a transmitting antenna and a receiving antenna, and electromagnetic waves are irradiated perpendicularly to the sample, as specified in JIS R1679:2007 (Measurement methods for reflectivity of electromagnetic wave absorber in millimetre wave frequency).
Here, the transmission attenuation can be calculated from the following formula using the transmission coefficient (absolute value).

Transmission attenuation = $20 \log_{10} |$ (Transmission coefficient) $|$

The transmission attenuation of the layered body of the example was 0.67 dB, and the transmission attenuation of the layered body of the comparative example was 48.32 dB.

(5) Measurement of spectral transmittance and spectral reflectance in range from infrared to ultraviolet

The spectral transmittance and spectral reflectance of the samples, which were prepared in the same manner as in the measurement of millimeter wave transmission attenuation, were measured in a range from infrared to ultraviolet using a UV-VIS-NIR spectrophotometer (PerkinElmer, Lambda 950).

In addition, for reference, the spectral transmittance and spectral reflectance in a range from infrared to ultraviolet were also measured for the polycarbonate (PC) substrate alone used as the substrate for the layered body.

The measurement conditions are as follows.

- An integrating sphere with a diameter of 150 mm was used.
- Standard sample (for 100% reflection): Spectralon manufactured by Labsphere.
- Wavelength range: 190 to 2500 nm.
- Wavelength interval: 5 nm steps.
- Measurement environment: Room temperature (25°C), in air.

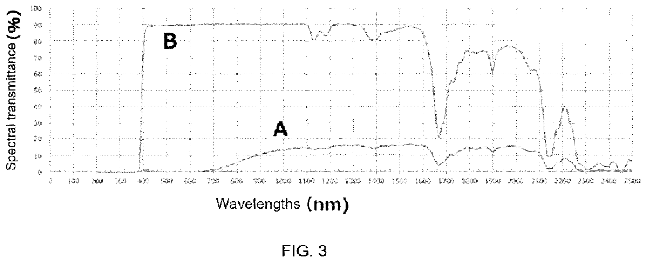

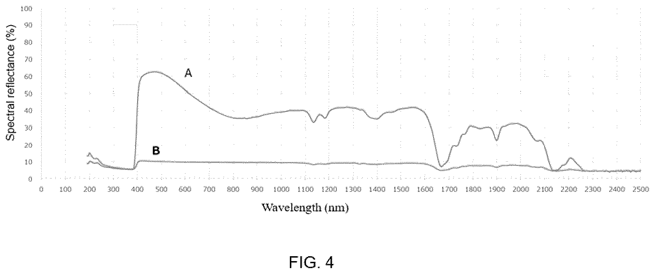

FIG. 3 shows the spectral transmittance spectra, and FIG. 4 shows the spectral reflectance spectra.

The spectral transmittance at a wavelength of 1000 nm in the infrared region was 13.7%, and the spectral transmittance at a wavelength of 600 nm in the visible light region was 0.1%.

The spectral reflectance at a wavelength of 1000 nm in the infrared region was 39.3%, and the spectral reflectance at a wavelength of 600 nm in the visible light region was 52.2%.

When red, blue and green light were irradiated from a back side of the layered body of the Example, the red, blue and green colors were clearly distinguishable on a front side by visual observation. Since the layered body of the Example has excellent metallic luster, when these colors were irradiated from the back side, a metallic red, blue and green colors appeared.

The disclosure of International Application No. PCT/JP2022/023687 is incorporated herein by reference in its entirety.

All documents, patent applications, and technical standards described herein are incorporated herein by reference to the same extent as if each individual document, patent application, and technical standard was specifically and individually indicated to be incorporated by reference.

**Claims**

1. A sensor cover comprising a substrate, and a silver particle layer provided on the substrate, the silver particle layer comprising a silver particle,
   wherein the silver particle has an electromagnetic wave transmission layer on a surface thereof.

2. The sensor cover according to claim 1, wherein the electromagnetic wave transmission layer is an organic layer.

3. The sensor cover according to claim 1 or claim 2, wherein the silver particle comprises a secondary particle, and the electromagnetic wave transmission layer is provided on a surface of a primary particle of the silver particle.

4. The sensor cover according to any one of claims 1 to 3, wherein the electromagnetic wave transmission layer is a millimeter wave transmission layer.

5. The sensor cover according to any one of claims 1 to 4, wherein the electromagnetic wave transmission layer is a layer that transmits at least a part of wavelengths in a range from infrared to visible light.

6. The sensor cover according to any one of claims 1 to 5, the sensor cover being a cover for a millimeter wave sensor or an infrared sensor.

FIG. 1

FIG. 2

FIG. 3

FIG. 4

## INTERNATIONAL SEARCH REPORT

| International application No. |
| --- |
| **PCT/JP2023/021985** |

### A. CLASSIFICATION OF SUBJECT MATTER

**B32B 15/02**(2006.01)i; **B32B 9/00**(2006.01)i; **B05D 5/12**(2006.01)i
FI: B32B15/02; B32B9/00 A; B05D5/12

According to International Patent Classification (IPC) or to both national classification and IPC

### B. FIELDS SEARCHED

Minimum documentation searched (classification system followed by classification symbols)

B32B15/02; B32B9/00; B05D5/12

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | WO 2022/014050 A1 (SHOWA DENKO MATERIALS CO., LTD.) 20 January 2022 (2022-01-20)<br>    claims, paragraphs [0052]-[0066], example 1 | 1-6 |
| X | JP 2019-177311 A (TOYODA GOSEI KK) 17 October 2019 (2019-10-17)<br>    claims, paragraphs [0009], [0023]-[0059], examples 1-4, table 1, fig. 1-9 | 1-6 |
| X | JP 2021-63305 A (SHOWA DENKO MATERIALS CO., LTD.) 22 April 2021 (2021-04-22)<br>    claims, paragraphs [0005], [0023]-[0027], [0051], [0053]-[0065], example 1, fig. 1 | 1-2, 4-6 |

☐ Further documents are listed in the continuation of Box C.     ☑ See patent family annex.

| | |
| --- | --- |
| *    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **01 August 2023** | **15 August 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

International application No.

**PCT/JP2023/021985**

| Patent document cited in search report | | | Publication date (day/month/year) | Patent family member(s) | Publication date (day/month/year) |
|---|---|---|---|---|---|
| WO | 2022/014050 | A1 | 20 January 2022 | (Family: none) | |
| JP | 2019-177311 | A | 17 October 2019 | (Family: none) | |
| JP | 2021-63305 | A | 22 April 2021 | US 2022/0220616 A1 claims, paragraphs [0010], [0065]-[0072], [0113], [0119]-[0158], fig. 1 EP 3940111 A4 CN 113905895 A | |

Form PCT/ISA/210 (patent family annex) (January 2015)

**REFERENCES CITED IN THE DESCRIPTION**

**Patent documents cited in the description**

- JP 2022082052 A
- JP 2022023687 W